## Europäisches Patentamt
## European Patent Office
## Office européen des brevets

(19)

(11) Numéro de publication: **0 019 502**
**A1**

(12) **DEMANDE DE BREVET EUROPEEN**

(21) Numéro de dépôt: **80400521.3**

(22) Date de dépôt: **18.04.80**

(51) Int. Cl.³: **G 01 D 13/22**
**B 60 Q 1/54, G 01 P 1/08**

(30) Priorité: **09.05.79 FR 7911723**

(43) Date de publication de la demande:
**26.11.80 Bulletin 80/24**

(84) Etats Contractants Désignés:
**DE GB IT**

(71) Demandeur: **SOCIETE ANONYME AUTOMOBILES CITROEN**
**117 à 167, Quai André Citroen**
**F-75747 Paris Cedex 15(FR)**

(71) Demandeur: **AUTOMOBILES PEUGEOT**
**75, avenue de la Grande Armée**
**F-75116 Paris(FR)**

(72) Inventeur: **Arnault, Dominique**
**28, Hameau des Grandes Vignes**
**F-28130 Maintenon Pierres(FR)**

(74) Mandataire: **Masseron, Georges**
**CENTRE TECHNIQUE CITROEN Chemin Vicinal No 2**
**F-78140 Velizy-Villacoublay(FR)**

(54) **Tableau de contrôle.**

(57) Tableau de contrôle d'informations, caractérisé, selon l'invention, en ce que l'affichage se manifeste au niveau d'un écran localisé fixe (1) formant spot médian, inscrit à l'intérieur d'un ensemble de cadres annulaires périphériques de rappel (2), (3), (4), (5), etc .... susceptibles d'être successivement et temporairement illuminés suivant une loi d'intervention et de progression séquentielle et synchrone tributaire de l'information affichée.

PL- unique

fig·1

Croydon Printing Company Ltd.

# Tableau de contrôle

L'invention concerne un tableau de contrôle regroupant un certain nombre de paramètres de fonctionnement affichés sous une forme propre à focaliser l'attention de l'observateur sur l'importance des marges de sécurité restant à sa disposition, susciter l'estime des conditions de fonctionnement par rapport à une règlementation donnée ou à des consignes particulières d'emploi telles que, par exemple, se rapportant aux contrôles de radio-activités, de niveaux thermiques, de coefficient de charge sur réseaux électriques ou à l'estimation de vitesses.

L'invention a pour objet un tableau de contrôle regroupant un certain nombre d'informations concernant divers paramètres de fonctionnement affichés au moyen d'une visualisation de type numérique ci-après défini dans le texte par l'appellation "digital", ou de type analogique, tel que par l'emploi de diodes électroluminescentes ou de cristaux liquides.

Suivant une première réalisation de l'invention l'affichage d'au moins un des paramètres se fait au niveau d'un écran localisé fixe formant spot médian, inscrit à l'intérieur d'un ensemble de cadres annulaires périphériques de rappel susceptibles d'être successivement et temporairement illuminés suivant une loi d'intervention et de progression séquentielle et synchrone tributaire de l'information affichée.

Suivant une autre caractéristique de l'invention, l'affichage est matérialisé sous forme de gammes numériques successives individuellement personnalisées par des colorations différentes au niveau du spot médian, chaque gamme correspondant à l'illumination d'un cadre annulaire privatif alimenté pendant toute la durée de la séquence considérée et de coloration identique à celle de l'affichage médian correspondant, la loi d'intervention et de progression synchrone, asservissant l'illumination des cadres aux affichages du spot, étant telle qu'à des séries croissantes de valeurs

2

affichées corresponde une succession d'allumages personnalisés progressant soit de la périphérie vers le centre du tableau, soit inversement, au niveau des cadres annulaires, ces derniers pouvant être disposés concentriquement et présenter des largeurs différentes fonction du niveau des valeurs affichées à l'intérieur de chaque séquence.

L'invention sera mieux comprise et d'autres caractéristiques apparaîtront à la lecture de la description qui va suivre et à l'examen des figures annexées matérialisant, d'une part la disposition générale de tableau revendiquée, d'autre part une forme de réalisation particulièrement bien adaptée à une utilisation sur véhicule automobile en vue d'un affichage des vitesses.

La figure 1 schématise une vue frontale d'un exemple de réalisation conforme à l'invention.

La figure 2 est une vue identique à celle de la figure 1, le tableau affichant un paramètre de faible valeur.

La figure 3 est une vue identique, le tableau affichant une valeur élevé susceptible de représenter un maximum au-delà duquel le danger ou l'infraction seraient effectifs.

La figure 4 est une vue correspondant à un exemple de géométrie triangulaire particulièrement avantageuse pour renforcer l'acuité des sensations de danger ou de marge de sécurité suivant la valeur affichée du paramètre.

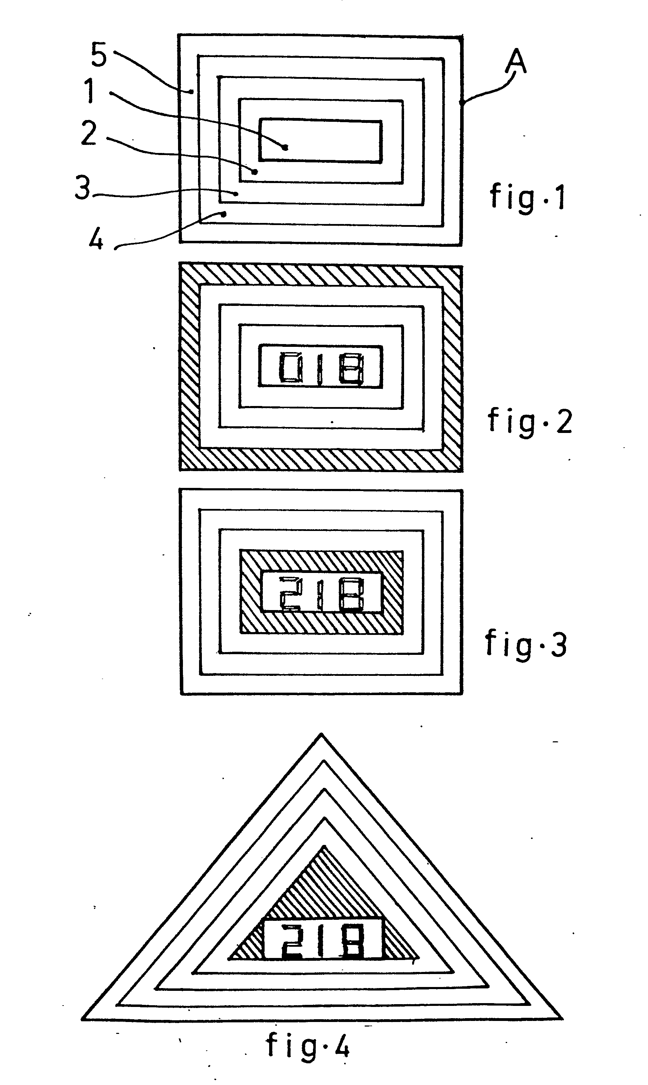

Tel que représenté figure 1, l'exemple de tableau, conforme à l'invention, est matérialisé sous la forme d'un quadrilatère de type rectangulaire A comportant un écran médian 1 destiné à l'affichage des informations analogique ou digitales dont le spot se trouve entouré d'une série de cadres annulaires périphériques concentriques 2, 3, 4, 5 dont l'éclairement sera tributaire de la valeur apparaissant sur l'écran 1. De façon plus précise, il y a lieu d'appuyer sur le fait que l'information, traduite en chiffres, pourcentages, ou coefficients appropriés au type d'affichage souhaité, se développe suivant un processus de gammes successives correspondant à des échelles de valeurs déterminées et personnalisées unitairement par une coloration différente pour chaque séquence de fragmentation ; ces échelles de valeurs étant individuellement soutenues et rappelées par l'éclairage successif d'un cadre annulaire périphérique concentrique différent, attribué à chacune d'elle, de coloration identique à celle de l'échelle considérée. Selon l'invention ce synchronisme de rappel est combiné d'autre part à un processus de couplage tel qu'à des séries croissantes de valeurs affichées corresponde une succession d'allumages progressant de la périphérie vers le centre du tableau de telle sorte

3

qu'en fait, les périmètres des encadrements annulaires illuminés soient inversement proportionnels aux tranches de valeurs affichées à l'intérieur des séries successives d'informations émises au niveau du spot médian. Ainsi la figure 2 matérialise-t-elle l'information d'une faible valeur du paramètre concerné par le contrôle (unité de gamme basse affichée au niveau du spot 1 et soutenue par l'illumination du cadre périphérique extérieur 5) à l'encontre de la figure 3 concernant l'affichage d'une unité de gammes hautes correspondant à l'illumination du cadre intérieur 2 enveloppant au plus près les contours du spot 1.

Pour accentuer la perception des notions de sécurité ou de danger que le dispositif revendiqué se propose de susciter dans l'esprit de l'observateur il est prévu d'illuminer les zones d'information selon un éventail de teintes s'échelonnant entre deux gammes extrêmes personnalisées, pour la gamme basse au moyen de la couleur verte symbole de sécurité et, pour la gamme haute, au moyen de la couleur rouge signalant conventionnellement le danger.

La géométrie du tableau peut, elle aussi, intervenir pour conforter l'impact pschychologique de sensibilisation aux notions de sécurité et de danger ; ainsi, réalisé sous une forme triangulaire avantageusement équilatérale et orientée de telle sorte qu'une de ses bases soit horizontale et un de ses sommets dirigé vers le haut (Fig. 4) la forme dudit tableau s'identifiera au symbole du signal de détresse : par ailleurs, l'existence d'un encadrement lumineux de rappel vert, éloigné du spot médian 1 et de vaste périmètre, sera générateur d'une impression sécurisante à l'encontre d'un encadrement lumineux rouge, éventuellement clignotant, très diaphragmé autour du spot sensibilisant l'observateur à la réaction d'alerte. En version triangulaire cette zone d'encadrement diaphragmée signalant le risque correspondra, tout naturellement, à la surface du triangle circonscrit au spot médian tel que représenté sur la figure 4. Il est encore possible d'accentuer la sensibilisation de l'observateur en agissant au niveau des bandes lumineuses d'encadrements dont la largeur peut être judicieusement modulée proportionnellement à l'importance de l'information affichée, une forme de réalisation triangulaire, correspondant à la version précédemment décrite, sera particulièrement bien adaptée à susciter la notion de vitesse de pointe. Il est évident que toute autre forme géométrique pourrait être utilisée, la forme circulaire par exemple, et que le mode d'affichage digital et analogique, ainsi que le type de disposition précédemment décrit, ne sauraient représenter de caractère limitatif, toutes modifications ou variantes apportées à la _

4

présente définition du tableau restant du domaine de l'invention ; ainsi, les cadres annulaires périphériques de rappels lumineux pourraient ne pas être concentriques et la progression du rappel lumineux synchrone de la séquence affichée intervenir au niveau de ces cadres annulaires de façon telle qu'à des séries croissantes de valeurs affichées corresponde une succession d'allumages progressant du centre vers la périphérie du tableau, processus inverse de l'exemple précédemment décrit.

5

# REVENDICATIONS

1. Tableau de contrôle regroupant un certain nombre d'informations concernant divers paramètres de fonctionnement affichés au moyen d'une visualisation de type analogique ou digital tel que par l'emploi de diodes électroluminescentes ou cristaux liquides ; caractérisé en ce que l'affichage d'au moins un des paramètres se fait au niveau d'un écran localisé fixe (1) formant spot médian, inscrit à l'intérieur d'un ensemble de cadres annulaires périphériques de rappel (2), (3), (4), (5), etc... susceptibles d'être successivement et temporairement illuminés suivant une loi d'intervention et de progression séquentielle et synchrone tributaire de l'information affichée.

2. Tableau de contrôle (A) selon la revendication 1, caractérisé en ce que les cadres annulaires périphériques (2), (3), (4), (5), etc ... sont concentriques.

3. Tableau de contrôle (A) selon les revendications 1 ou 2, caractérisé en ce que le rappel lumineux synchrone de la séquence affichée intervienne au niveau des cadres annulaires périphériques (2), (3), (4), (5), etc ... de façon telle qu'à des séries croissantes de valeurs affichées corresponde une succession d'allumages progressant de la périphérie vers le centre du tableau (A).

4. Tableau de contrôle (A) selon les revendications 1 ou 2, caractérisé en ce que le rappel lumineux synchrone de la séquence affichée intervienne au niveau des cadres annulaires périphériques (2), (3), (4), (5) etc ... de façon telle qu'à des séries croissantes de valeurs affichées corresponde une succession d'allumages progressant du centre vers la périphérie du tableau (A).

5. Tableau de contrôle (A) selon l'une quelconque des revendications précédentes, caractérisé en ce que chaque série de valeurs affichées est personnalisée par une coloration différente au niveau du spot médian (1), le cadre annulaire périphérique correspondant à la séquence concernée étant illuminé d'une coloration identique à celle de l'affichage se manifestant au niveau dudit spot.

6. Tableau de contrôle (A) selon l'une quelconque des revendications précédentes, caractérisé en ce que l'affichage au niveau du spot médian (1) clignote ainsi que le cadre annulaire correspondant à partir d'un certain seuil de valeur limite.

7. Tableau de contrôle (A) selon les revendications précédentes, caractérisé en ce que la largeur des cadres annulaires périphériques (2), (3), (4), (5), etc ... est variable, et en ce que cette largeur est proportionnelle à la valeur de la somme des affichages constituant la séquence considérée.

8. Tableau de contrôle (A) selon l'une quelconque des précédentes revendications, caractérisé en ce que les cadres annulaires périphériques entourant le spot médian (1) sont des triangles.

9. Tableau de contrôle (A) selon l'une quelconque des revendications précédentes, caractérisé en ce que les colorations effectives au niveau du spot médian (1) et des cadres annulaires périphériques (2), (3), (4), (5) etc ... s'échelonnent à l'intérieur d'une gamme de teintes attribuant la couleur verte aux premières séquences d'affichages de paramètres de faibles valeurs, et la couleur rouge aux séquences concernant les affichages de paramètres à fortes valeurs.

10. Tableau de contrôle (A) selon l'une quelconque des revendications précédentes, caractérisé en ce qu'il est utilisé pour l'affichage de valeurs tachymétriques, et particulièrement celles des paramètres concernant le déplacement d'un véhicule automobile.

PL-unique

0019502

fig·1

fig·2

fig·3

fig·4

0019502

**Office européen des brevets**

## RAPPORT DE RECHERCHE EUROPEENNE

Numéro de la demande

EP 80 40 0521

| Catégorie | Citation du document avec indication, en cas de besoin, des parties pertinentes | Revendication concernée | CLASSEMENT DE LA DEMANDE (Int. Cl. ³) |
|---|---|---|---|
| | **DOCUMENTS CONSIDERES COMME PERTINENTS** | | |
| | FR - A - 2 403 560 (FRATELLI BOR-LETTI S.P.A.) <br><br> * Revendications 1-3,7-8; figures 1-3 * <br> -- | 1,3,10 | G 01 D 13/22 <br> B 60 Q 1/54 <br> G 01 P 1/08 |
| | DE - B - 1 623 874 (V.D.O. TACHOME-TER WERKE) <br><br> * Revendications 1',19-21; colonne 3, lignes 19-27; colonne 13, lignes 24-42; figures 8-9 * <br> -- | 1-2,10 | |
| | DE - A - 2 450 081 (PETER J. GRUBE) <br><br> * Revendications 1-4; page 2, ali-néas 2-3; page 2, alinéas 1-4 * <br> -- | 1,9-10 | **DOMAINES TECHNIQUES RECHERCHES (Int. Cl. ³)** <br><br> G 09 F 9/30 <br> 9/35 <br> G 01 D 13/22 <br> 13/00 <br> 7/00 |
| | US - A - 4 041 782 (ELMER J. HINGST) <br><br> * Revendication 1; figure 2 * <br> -- | 1,6,10 | G 01 R 13/00 <br> 13/40 <br> G 01 P 1/08 <br> 1/10 <br> G 02 F 1/13 |
| | DE - B - 1 042 927 (WALTER VOLLMER) <br><br> * Revendication * <br> -- | 1,6,10 | B 60 Q 1/54 <br> 9/00 <br> B 60 K 35/00 |
| | GB - A - 1 170 259 (ALFRED FUETSCH) <br><br> * Revendications 1 et 4; page 2, lignes 73-100; figure 7 * <br> ---- | 1,5,9-10 | |

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons
&: membre de la même famille, document correspondant

X Le présent rapport de recherche a été établi pour toutes les revendications

| Lieu de la recherche | Date d'achèvement de la recherche | Examinateur |
|---|---|---|
| La Haye | 14.08.1980 | FRANSEN |

OEB Form 1503.1 06.78